# EUROPEAN PATENT APPLICATION

(11) **EP 2 860 538 A1**
(43) Date of publication of application: **15.04.2015**
(21) Application number: 14187356.2
(22) Date of filing: 01.10.2014
(51) Int. Cl.: G01R 31/327, G01R 31/40, G01R 31/42, G01R 31/02, G01R 19/165, G01R 31/04

(54) **Locating loose connections in an electrical circuit**

(30) Priority: 11.10.2013 US 201314052211
(71) Applicant: General Electric Company, Schenectady, New York 12345 (US)
(72) Inventor: Casteel, Jordan Brantley, Salem, VA 24153 (US); Leonard, John Andrew, Salem, VA 24153 (US); Pearson, William Robert, Salem, VA 24153 (US); Rowny, Joseph Clark, Salem, VA 24153 (US)
(74) Representative: Cleary, Fidelma

(57) **Abstract**

An electrical system (100) includes an electrical circuit (110) having a plurality of current paths (P1,P2,P3) and a plurality of switches (SW1,SW2,SW3) for directing current to the plurality of current paths (P1,P2,P3). A sensor (CS1,CS2,CS3) senses a current or voltage in the electrical circuit. A processor connected to the sensor (CS1,CS2,CS3) receives sensor data corresponding to the current or voltage in the circuit. The processor is configured to determine a location of a loose connection in the electrical circuit (110) based on the current or voltage data and a switching sequence of the plurality of switches. (SW1,SW2,SW3).

## Description

### BACKGROUND OF THE INVENTION

The subject matter disclosed herein relates to electrical circuits and, in particular, to locating loose connections in electrical circuits.

Electrical circuits, including power converters, employ solid-state switches that are connected to an alternating current (AC) or direct current (DC) power source. The switches are closed and opened in a precisely controlled manner to generate a regulated AC or DC voltage or current to meet a specific load requirement. Loose connections in an electrical circuit may cause intermittent or continuous arcing or sparking. The sparking and arcing produce conducted and radiated energy at frequencies that are not normally present in the electrical circuit, and may damage electrical components and systems connected to the electrical circuit.

### BRIEF DESCRIPTION OF THE INVENTION

According to one aspect of the invention an electrical system includes an electrical circuit having a plurality of current paths and a plurality of switches for directing current to the plurality of current paths. A sensor senses a current in the electrical circuit. A processor connected to the sensor receives sensor data corresponding to the current in the circuit. The processor is configured to determine a location of a loose connection in the electrical circuit based on the current data and a switching sequence of the plurality of switches.

According to another aspect of the invention, an apparatus for locating a loose connection in an electrical circuit includes a processing circuit connected to a sensor to receive sensor data corresponding to a current in the electrical circuit. The electrical circuit includes a plurality of current paths and a plurality of switches to switch a flow of current among the plurality of current paths. The processing circuit identifies a current variation in the sensor data corresponding to a loose connection in the electrical circuit and identifies a location of the loose connection based on a location of the sensor, a time of the current variation, and a switching sequence of the plurality of switches.

According to yet another aspect of the invention, a method for finding a loose connection in an electrical circuit includes providing current to an electrical circuit having a plurality of current paths, controlling a plurality of switches in a predetermined sequence to direct current to the plurality of current paths in a predetermined order, measuring a current in the electrical circuit, and detecting a pattern corresponding to a loose connection in the electrical circuit. The method also includes identifying the location of the loose connection in the electrical circuit based on the detected pattern.

These and other advantages and features will become more apparent from the following description taken in conjunction with the drawings.

### BRIEF DESCRIPTION OF DRAWINGS

The subject matter, which is regarded as the invention, is particularly pointed out and distinctly claimed in the claims at the conclusion of the specification. The foregoing and other features, and advantages of the invention are apparent from the following detailed description taken in conjunction with the accompanying drawings in which:
FIG. 1 illustrates a system for locating a loose connection in an electrical circuit according to an embodiment of the invention;
FIG. 2 illustrates an example of a system according to an embodiment of the invention;
FIG. 3 illustrates an example of a system according to another embodiment of the invention; and
FIG. 4 is a flow diagram of a method according to an embodiment of the invention.

The detailed description explains embodiments of the invention, together with advantages and features, by way of example with reference to the drawings.

### DETAILED DESCRIPTION OF THE INVENTION

Conventional electrical circuits require manual inspection to find loose connections in the circuit. Embodiments of the invention relate to electronic systems and processing circuits implementing methods of locating loose connections in electrical circuits.

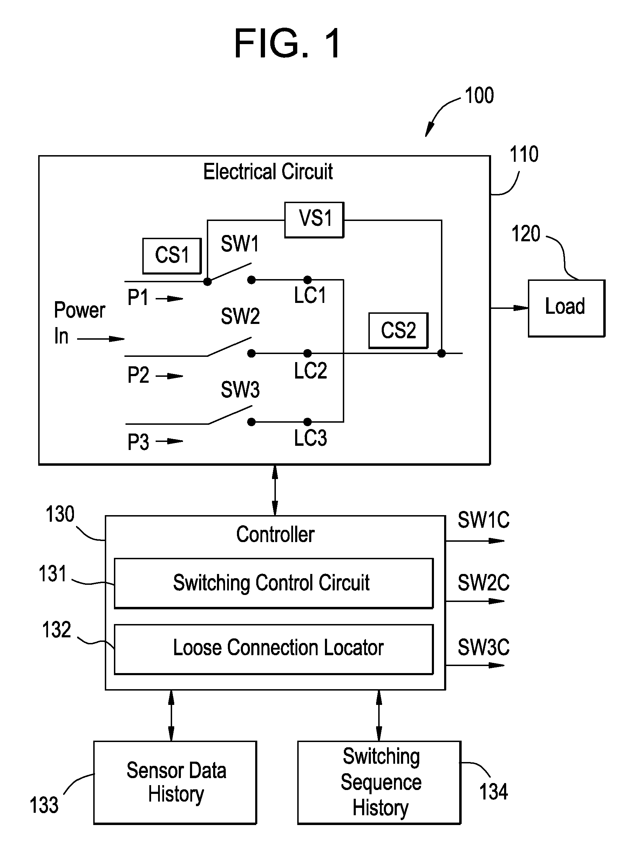

FIG. 1 illustrates a system 100 according to an embodiment of the invention. The system 100 includes an electrical circuit 110 that receives a power signal as an input and outputs a power signal to a load 120. The system 100 also includes a controller 130 that controls switching of the switches SW1, SW2, and SW3 in the electrical circuit 110.

In embodiments of the invention, the electrical circuit 110 includes multiple current paths. In FIG. 1, the multiple current paths P1, P2, and P3 include switches SW1, SW2, and SW3, which are opened to prevent current flow through the paths P1, P2, and P3, respectively. Conversely, closing the switches SW1, SW2, or SW3 permits current flow through the paths P1, P2, or P3, respectively. In one embodiment, the switches SW1, SW2, and SW3 are solid-state switches, such as semiconductor transistors.

The switches are opened and closed by the switching control circuit 131 of the controller 130. The switching control circuit 131 may include pulse-width modulation circuitry, comparators, and any other circuitry that may determine a state of the switches SW1, SW2, and SW3, measure timing of the switching, or otherwise control the sequence of opening and closing the switches SW1, SW2, and SW3. The controller 130 controls the switches SW1, SW2, and SW3 by generating control signals SW1C, SW2C, and SW3C. For example, in embodiments in which the switches SW1, SW2, and SW3 are transistors, the control signals SW1C, SW2C, and SW3C may be gate voltage signals to turn on and off the transistors.

The electrical circuit 110 also includes sensors CS1 and CS2, which may be, for example, high-frequency current sensors to sense current along a particular current path or group of paths. The circuit 110 may also include sensors such as VS1, which may be high-frequency voltage sensors to sense voltage drops along a particular path of the circuit. The sensors VS1, CS1 and CS2 transmit sensor data to the controller 130, where a loose connection locator 132 analyzes the data from the sensors, determines whether a loose connection exists, and locates the loose connection in the electrical circuit 110.

In one embodiment, the controller 130, which includes a processor or processing circuit, receives the sensor data and identifies a current or voltage variation in the sensor data. The variations include spikes or high-frequency noise, for example. The controller 130 analyzes the sensor data and identifies the presence of the loose connections based on the current or voltage variations. The controller 130 then isolates the loose connection, or identifies the location of the loose connection, based on the variations.

Referring to FIG. 1, a sensor CS1 may be located along a current path P1, so that if a current variation corresponding to a loose connection LC1 is detected by the sensor CS1, the controller 130 determines that the loose connection LC1 is located along the current path P1. However, in an electrical circuit 110 having multiple current paths, it may be costly or impractical to have a sensor located along each current path. The sensor CS2 may be located in the electrical circuit 110 and may detect current along multiple current paths P1, P2, and P3. In other words, the sensor CS2 will sense a current variation corresponding to a loose connection if any one of the current paths P1, P2, or P3 has a loose connection C1, C2, or C3.

In the event that the sensor CS2 senses a current variation corresponding to a loose connection (LC1, LC2, or LC3), the controller 130 determines a time that the loose connection occurred. The controller 130 then analyzes a switching sequence of the switches SW1, SW2, and SW3 to determine which switch or switches were activated at the time that the loose connection occurred. In one embodiment, the controller 130 accesses a switching sequence history 134, which may include data stored in memory, including a switching sequence data that is associated with time data.

As an example, if the current path P3 has a loose connection LC3, the sensor CS2 will sense a periodic current variation corresponding to the closing of the switch SW3 to pass current through the current path P3. The controller 130 determines the time or times that the current variation occurs and analyzes the switching sequence to identify that the current variation occurred when the when the switch SW3 was switched on. Accordingly, the controller 130 identifies the current path P3 as the source of the loose connection LC3.

In some embodiments, a loose connection may be an intermittent loose connection. For example, the loose connection LC3 may not generate a current variation corresponding to a loose connection each time the switch SW3 is closed. In such an embodiment, the controller 130 analyzes the sensor data history 133 to determine previous current variations corresponding to the loose connection LC3. The controller 130 also analyzes the sequence switching history 134 to determine that the previous occurrences of the current variations corresponded to the switch SW3.

While the loose connections LC1, LC2, and LC3 are illustrated along the current paths P1, P2, and P3, embodiments of the invention encompass loose connections that are detected in any current path of the electrical circuit. In addition, while the loose connections LC1, LC2, and LC3 are illustrated along lines representing current flow in a circuit, loose connections may be located anywhere in a circuit, including at junctions of components and wiring, at junctions of wiring and a circuit board, at junctions of components and a circuit board, or at any location along a current path in an electrical circuit.

In addition, while FIG. 1 illustrates sensors CS1 and CS2 that monitor current paths directly, embodiments of the invention encompass sensors that monitor parallel paths. For example, a main current path may transmit a majority of current to a destination load, and a sensing current path may run parallel to the main current path and may draw a current less than the main current path. The current sensor may be located along the sensing current path to monitor the main current path by monitoring the lower current levels of the sensing current path and extrapolating current characteristics of the main current path.

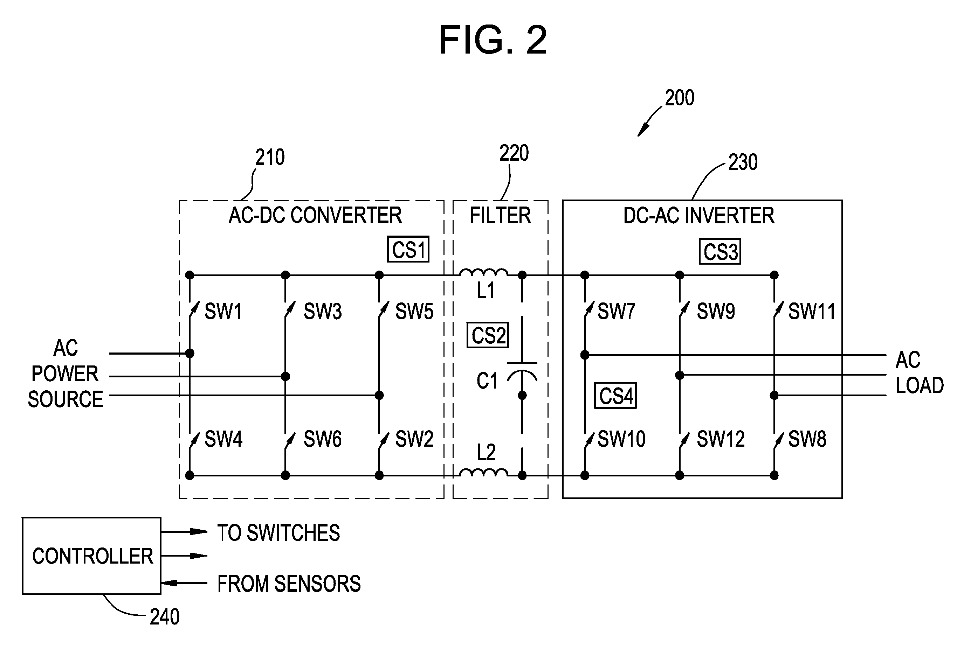

FIG. 2 illustrates a system 200 for locating a loose connection according to an embodiment of the invention. The system 200 includes an electrical circuit to convert one alternating current (AC) power level to another AC power level. For example, the system 200 may convert AC power from a power grid to an AC power level of a different voltage or frequency to control a motor load. In one example embodiment, the system 200 is a generator static starter, which operates a power utility generator as a synchronous motor during startup to bring the generator from near standstill up to a speed at which it can be connected to a gas or steam turbine as the prime mover source for the generator. However, embodiments of the invention encompass any use of the system 200.

The system includes an alternating current (AC) to direct current (DC) converter 210, a filter 220, and a DC-AC inverter 230. The system 200 includes electrical switches SW1-SW12, which represent solid state semiconductors, such as rectifiers, silicon controlled rectifiers or thyristors, transistors, such as insulated gate bipolar transistors (IGBTs), and any other solid-state semiconductor devices in any configuration to provide various voltage, current, and performance capabilities. The system 200 includes other components such as sensors, snubbers, and protective devices which have been omitted from FIG. 2 for purposes of clarity in describing an embodiment of the invention.

The filter 220 is illustrated as including inductors L1 and L2 and a capacitor C1, although embodiments of the invention encompass any type of filter including any number of components.

The system 200 also includes a controller 240 which operates the switches SW1-SW6 in synchronism with the AC power source to form an intermediate dc voltage. Switches SW7-SW12 are then operated by the controller 240 to convert the DC voltage to the appropriate AC waveforms required by the load, by using the various sensors.

The system includes current sensors CS1, CS2, CS3, and CS4. Each current sensor may detect currents along different current paths, and embodiments of the invention encompass detecting locations of loose connections in the system 200. For example, since the current sensor CS1 is in a main current path of the system, it would detect any loose connections in the AC-DC converter 210, the DC-AC inverter 230, or the filter 220. If the current sensor CS1 detects a current variation corresponding to a loose connection, the controller 240 may analyze switching sequence data for the switches SW1 to SW12 to determine which switches were closed at the time of the current variation, and the controller 240 may then identify the location of the loose connection. A correlation of sensor data with the sequence of a particular switch identifies a loose connection in that switch leg. Correlation with the sequence of multiple switches identifies a loose connection in a specific source or load phase. Lack of correlation with specific switching patterns indicates a loose connection in the filter or the connections between 210 and 230.

Current sensor CS2 is in parallel with the main current paths of the system. This location carries lower current than at location CS1, and also can use an AC sensor whereas CS1 must be capable of DC current sensing. CS2 may therefore be a lower cost sensor than CS1. Nevertheless current sensor CS2 can detect a current variation, and discern the location of the loose connection in same manner as CS1. Current sensors CS3 and CS4, being located in specific switch legs, are only capable of detecting loose connections when the corresponding switch SW10 or SW11 is closed. Hence, if there were a loose connection at SW7, CS4 would not be capable of detecting it since SW7 and SW10 cannot be closed at the same time (a short circuit across the DC bus would occur). However, CS1 and CS2 could detect the loose connection at SW7 when SW7 is closed along with either SW8 or SW12. In some applications, CS3 could also detect the loose connection at SW7 if current can circulate through the load when both SW7 and SW11 are closed. In each of these examples, the controller 240 may analyze the switching sequence data to determine which switches among the switches SW1-SW12 were turned on when the current variation occurred, and determine the location of the loose connection.

The electrical circuit illustrated in FIG. 2 is one type of power converter, but embodiments of the invention are not limited to the embodiment illustrated in FIG. 2, but encompass any power converters, and in particular, power converters having multiple current paths between a power source and a load. Embodiments of the invention also encompass any electrical circuit other than power converters having multiple current paths between a power source and a load in which a loose connection may occur.

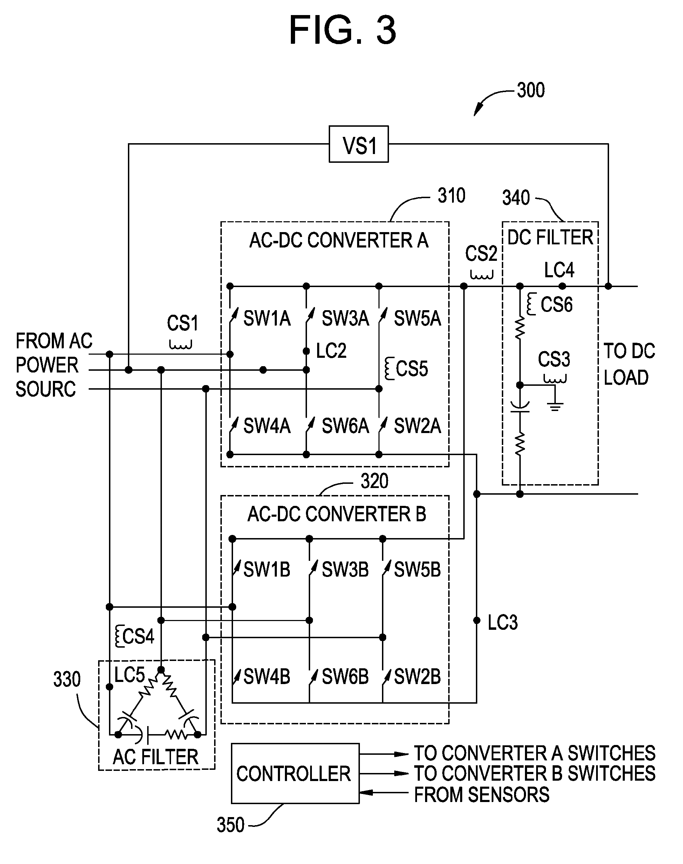

FIG. 3 illustrates a system 300 for locating a loose connection in an electrical circuit according to another embodiment of the invention. The system 300 includes a first AC-DC converter 310, a second AC-DC converter 320, an AC filter 330, a DC filter 340, and a controller 350. In one embodiment, the system 300 may be used to power a DC load, such as a DC motor, a field of a synchronous motor, or a power supply using power from an AC power grid. In one embodiment, the system 300 is a generator field exciter, which typically requires high reliability. As a result, the two AC-DC converters 310 and 320 connected in parallel between the AC power source and the DC load provide redundancy for greater generator availability. While a few examples of embodiments of the system 300 have been described, the invention is not limited to the aforementioned examples. Instead, embodiments of the invention encompass any system connected between power and a load having multiple, redundant current path elements to provide greater reliability or for other design considerations.

As illustrated in FIG. 3, the first AC-DC converter 310 includes switches SW1A-SW6A, and the second AC-DC converter 320 includes switches SW1B-SW6B. The switches SW1A-SW6A and SW1B-SW6B are controlled by the controller 350 to operate the switches according to a predetermined sequence to convert power from AC power to DC power. The AC filter 330 include resistors R1-R3 and capacitors C1-C3, and the DC filter 340 includes resistors R4 and R5 and capacitors C4 and C5. The AC filter 330 and the DC filter 340 are provided by way of example, and embodiments of the invention are not limited to systems including filters having these configurations. Instead, any configuration may be used according to the requirements of the electrical system, or no AC or DC filter may be provided.

The system 300 includes current sensors CS1, CS2, CS3, CS4, CS5, and CS6. Each current sensor CS1-CS6 detects a current at a different location in the system 300. While the current sensors CS1-CS6 are provided by way of example, embodiments of the invention encompass current sensors at any location in the system 300. In the system 300, the current sensor CS1 measures current in one of the supply phases from the AC power source. Similarly, current sensor CS5 measures current in only one leg, corresponding to switch SW5A, of the first AC-DC converter 310. CS4 and CS6 each measure current in one pole of the AC filter 330 and the DC filter 340, respectively. CS3 measures current at a ground potential in filter 340. CS3, CS4 and CS6 are located in current paths with much lower currents compared to the other sensors. In addition, these sensors, along with CS1, need only to detect AC currents and may be lower cost than DC current sensors. Current sensor CS2 measures the DC current output from both of the AC-DC converters 310 and 320.

In embodiments of the invention, the current sensors CS1-CS6 may be implemented by any appropriate instrument capable of measuring current in an operating circuit, including current transformers, resistive shunts, Rogowski coils, Hall Effect devices, or any other instruments.

FIG. 3 illustrates four examples of locations of loose connections LC1-LC4 in the system 300, but loose connections may occur anywhere in the system 300. In embodiments of the invention, the locations of the loose connections L1-L4 are determined based on the current sensed by the current sensors CS1-CS6. For example, if a loose connection LC1 exists, the loose connection LC1 could be detected by the current sensors CS1, CS2, or CS5, as there are switching sequences such that current flows through LC1 and the respective sensors. Accordingly, the controller 350 may receive the current sensor data from the current sensors CS1, CS2, or CS5, and may analyze switching sequence information to determine the location of the loose connection LC 1.

In particular, the controller 350 may determine a time at which the loose connection LC1 is detected and may analyze the switching sequence information to determine that the time at which the loose connection LC 1 is detected corresponds only to a time that either switch SW3A or SW6A is turned on. Therefore the controller determines that the loose connection location must be in the middle phase of the ac power source.

In another example, the current sensor CS6 may detect a high frequency noise only during intervals when a switch SW3A is turned on. The high-frequency noise may be generated by a loose connection LC2 that generates sparking due to a voltage breakdown across the loose connection LC2. Once established, the sparking is maintained by inductances in the system 300 until a transition to another current path occurs, resulting in the high-frequency noise during the activation time of the switch SW3. Since sparking creates high-frequency voltage variations across a loose connection gap, the voltage variations can appear in other locations in the converter, including locations, such as the location corresponding to the current sensor CS6, that are not directly in series with the loose connection, due to parasitic capacitances in the system 300. Based on the time at which the high-frequency noise occurs and the switching sequence information, the controller 350 may determine the location of the loose connection LC2 in this example.

In addition, since the AC-DC converters 310 and 320 are connected in parallel, the controller 350 may perform additional analysis to determine in which AC-DC converter 310 or 320 the loose connection LC1 is located. In one embodiment, the additional analysis includes turning off the AC-DC converters 310 and 320 one-at-a-time, while running the other AC-DC converter 310 or 320. Accordingly, when the controller 350 turns off the first AC-DC converter 310 and runs the second AC-DC converter 320 according to a predetermined switching sequence, the controller 350 will not detect any current variations corresponding to the loose connection LC1, and the controller 350 will determine that the loose connection LC1 is not in the second AC-DC converter 320. In contrast, when the controller 350 turns off the second AC-DC converter 320 and runs the first AC-DC converter 310 according to a predetermined switching sequence, the controller 350 will detect current variations corresponding to the loose connection LC1, and the controller 350 will determine that the loose connection LC1 is located in the first AC-DC converter 310. As a result of analyzing the time of the current variations, the switching sequence information, and modifying the switching sequence of the switches by turning off the AC-DC converters 310 and 320 one-at-a-time, the controller 350 may isolate the loose connection LC1.

While an example of modifying a switching sequence includes turning off one redundant power converter, as discussed above, embodiments of the invention encompass any type of modification of a switching sequence to determine a location of a loose connection, including changing an order in which switches are turned on and off, turning off switches of one current path while running switches of another current path, or performing any other modification to a switching sequence that varies the operation of the switches from a normal operation of the switches (e.g., a normal sequence to provide power to a load) to locate a loose connection.

FIG. 3 also illustrates a voltage sensor VS1 connected between an input and an output of the converter system 300. In alternate embodiments of the invention, one or more voltage sensors may be used in conjunction with or instead of current sensors. As can be seen in FIG. 3, when SW3A is closed and SW3B is opened, sensor VS1 could detect voltage variations caused by loose connection LC1 or LC2. By using additional voltage sensors and switching sequence modifications as described above, controller 240 could discriminate between loose connections LC1 or LC2.

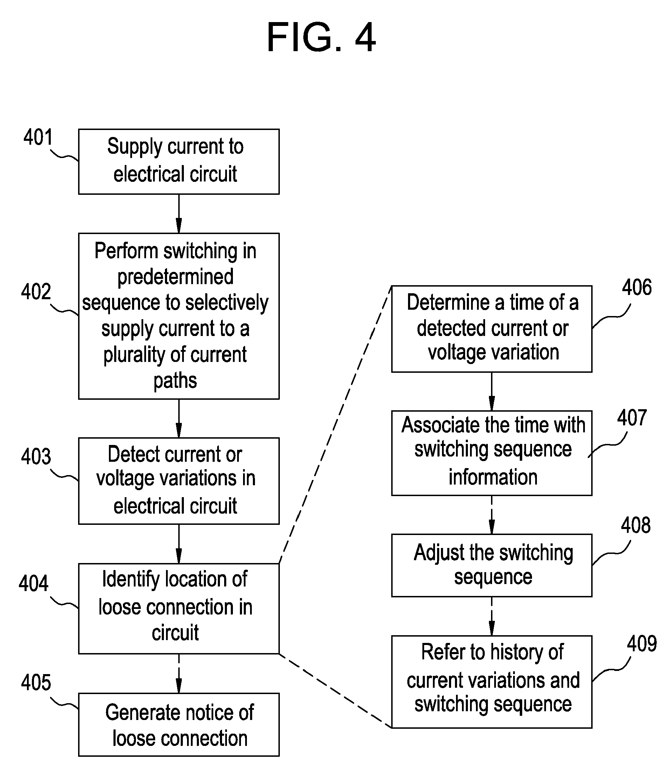

FIG. 4 is a flow diagram of a method according to an embodiment of the invention. In block 401, an electrical current is supplied to an electrical circuit. The electrical circuit includes multiple current paths between a power source and a load, and at least one current sensor to detect current characteristics in the multiple current paths. Current is selectively passed through the current paths with switches, and in particular, with solid-state switches, such as transistors.

In block 402, a controller activates the switches in a predetermined sequence to selectively supply current to the plurality of current paths. For example, in an embodiment in which the electrical circuit is a power converter, switches may be used to convert power from an AC signal to a DC signal, or from a DC signal to an AC signal.

In block 403, current or voltage variations in the electrical circuit are detected. In particular, current or voltage patterns corresponding to loose connections are detected. The variations or patterns may include spikes or increased high-frequency noise. In one embodiment, the sensor signals are converted via a Fourier transform into the frequency spectrum present during each switching sequence. Frequency components due to normal operation of the switches are subtracted from the spectrum. Remaining high frequency components of sufficient magnitude are characteristic of arcing current waveforms, and indicate a loose connection exists.

In block 404, a controller including a processor or processing circuit identifies a location of the loose connection in the electrical circuit based on the detected current or voltage variations. For example, if a current sensor is associated only with one leg of the circuit, then the processing circuit may determine that the loose connection is located in that leg. If the current sensor is associated with multiple legs or current paths, then the processing circuit may perform additional steps 406 through 409 to identify the location of the loose connection.

In block 406, the processing circuit determines a time that the current or voltage variation is detected. The time may be an absolute time (i.e., time of day), a time relative to the time that the analysis is performed (e.g., "last occurrence was five milliseconds ago"), a system time based on an internal clock of the electrical system being run, or any other way of determining a time. In block 407, the determined time is associated with the predetermined switching sequence that is used to control switches in the electrical circuit. For example, a processing circuit may determine that a particular switch was active at the time the current or voltage variation was determined, and the processing circuit may identify a location of the loose connection as being along the current path associated with the switch.

In some embodiments, multiple current paths are run simultaneously in parallel. In such an embodiment, a processing circuit may perform additional actions to identify the location of the loose connection. In block 408, a processing circuit adjusts a switching sequence of switches in the electrical system. For example, the processing circuit may turn off one portion of the electrical system and may leave running the other portion. Accordingly, the processing circuit may determine in which parallel current paths the current or voltage variation is originating.

In some embodiments, a loose connection occurs only intermittently. In other words, if the loose connection is located along a current path associated with a particular switch, a current variation corresponding to the loose connection will not be detected each time the switch is activated. In such an embodiment, a processing circuit may perform an additional analysis, indicated in block 409, of the history of current variations and the history of the switching sequence to identify the current path in which the loose connection is located. For example, the processing circuit may determine that the current variations have occurred intermittently when a particular switch is activated, and the processing circuit may then identify the location of the loose connection as being in the current path associated with the particular switch.

In block 405, a notice is generated to notify a user or a system of the loose connection. The notice may be any sensory notice, including audio, visual, or tactile. In one embodiment, the notice includes information regarding the location of the loose connection. For example, the notice may tell an operator to check a particular current path for a loose connection. As a result, catastrophic damage caused by loose connections and current arcing may be prevented.

Embodiments of the invention relate to systems, devices and methods of detecting loose connections in electrical circuits, and in particular, to locating the loose connections in the electrical circuits. In embodiments of the invention, current or voltage sensors in an electrical circuit detect voltage and current characteristics and provide sensor data to a processing circuit. The processing circuit analyzes the sensor data and locates the loose connection based on the sensor data. In embodiments in which the sensor is associated with multiple current paths, the processing circuit locates the loose connection based on a time that a voltage or current variation occurs and switching sequence information of switches in the electrical circuit. Accordingly, loose connections may be located even in electrical circuits having multiple current paths.

In embodiments of the invention, locating a loose connection based on a time of a voltage or current variation and switching sequence information may include analyzing voltage or current patterns. For example, a first loose connection LC1 may generate a first voltage or current pattern over time that varies from a normal operating pattern of the system 300, and a third loose connection LC3 may generate a second, different, voltage or current pattern over time. Accordingly, the controller 350 may analyze the voltage or current patterns over time to locate the loose connections.

In embodiments of the invention, the locations of intermittent loose connections may be determined and isolated voltage and current variation events may be disregarded by analyzing the voltage or current data over time and the switching sequence data over time. If the analysis indicates that a particular voltage or current variation recurs intermittently, then it may be determined that a loose connection exists, and a notice may be generated to notify an operator or system. If it is determined that the voltage or current variation does not recur, then the voltage or current variation may be disregarded as a one-time event, such as a voltage or current surge caused by a lightning strike or other event.

In additional embodiments of the invention, a loose connection may be located in an electrical system having multiple, parallel current paths by modifying a switching sequence of switches in the electrical system when a voltage or current variation corresponding to a loose connection is detected. The switching sequence may be modified to turn off one parallel current path while running another, for example.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

## Claims

1. An electrical system (100), comprising:
an electrical circuit (110) having a plurality of current paths (P1, P2, P3) and a plurality of switches (SW1, SW2, SW3) for directing current to the plurality of current paths (P1, P2, P3);
a sensor (CS1, CS2, CS3) for sensing at least one of current and voltage in the electrical circuit (110); and
a processor connected to the sensor (CS1, CS2, CS3) to receive sensor data corresponding to the current or voltage in the electrical circuit (110) and configured to determine a location of a loose connection in the electrical circuit (110) based on the sensor data and a switching sequence of the plurality of switches (SW1, SW2, SW3).

2. The electrical system of claim 1, wherein the electrical circuit (110) is an electronic power converter circuit and the plurality of current paths (P1, P2, P3) includes multiple phases of the power converter circuit.

3. The electrical system of claim 1 or 2, wherein the sensor (CS1, CS2, CS3) is a high frequency current sensor.

4. The electrical system of claim 1, 2, or 3, wherein determining the location of the loose connection includes determining that the sensor (CS1, CS2, CS3) has sensed one of a voltage variation and a current variation corresponding to the loose connection, identifying a plurality of current paths (P1, P2, P3) associated with the sensor (CS1, CS2, CS3), identifying a time at which the sensor data corresponding to the loose connection was detected, and analyzing the switching sequence to determine which current path among the plurality of current paths (P1, P2, P3) was passing current at the time at which the sensor data corresponding to the loose connection was detected.

5. The electrical system of claim 1, 2, 3, or 4, wherein determining the location of the loose connection includes modifying the switching sequence of the plurality of switches (SW1, SW2, SW3) based on detecting the sensor data corresponding to the loose connection.

6. The electrical system of claim 5, wherein the processor is configured to modify the switching sequence of the plurality of switches (SW1, SW2, SW3) to stop current flow through a first current path among the plurality of current paths (P1, P2, P3) while operating the plurality of switches (SW1, SW2, SW3) in a second current path among the plurality of current paths (P1, P2, P3).

7. The electrical system of any preceding claim, wherein the processor is configured to detect an intermittent loose connection based on the sensor data, and
determining the location of the loose connection in the electrical circuit (110) includes analyzing a history of the sensor data and a history of the switching sequence to identify previous instances of the loose connection in the history of the sensor data and to associate the previous instances with a current path among the plurality of current paths (P1, P2, P3) based on the history of the switching sequence.

8. A method for locating a loose connection in an electrical circuit (110), comprising:
providing current (401) to an electrical circuit (110) having a plurality of current paths (P1, P2, P3);
controlling a plurality of switches (SW1, SW2, SW3) in a predetermined sequence (402) to direct current to the plurality of current paths (P1, P2, P3) in a predetermined order;
measuring at least one of current and voltage (403) in the electrical circuit 110;
detecting a pattern corresponding to a loose connection based on measuring the current or voltage; and
identifying a location of the loose connection (404) in the electrical circuit (110) based on detecting the pattern corresponding to the loose connection.

9. The method of claim 8, wherein identifying the location of the loose connection includes identifying a location of a sensor (CS1,CS2,CS3) in the electrical circuit (110) that is measuring the current or voltage and identifying a current path (P1,P2,P3) among the plurality of current paths that corresponds to the sensor (CS1,CS2,CS3).

10. The method of claim 8 or 9, wherein identifying the location of the loose connection includes passing sensor data corresponding to measuring the current or voltage through a transform algorithm to detect a presence of the loose connection.

11. The method of claim 8 or 9, wherein identifying the location of the loose connection comprises:
determining a time at which the pattern corresponding to the loose connection occurs;
determining a state of a switching sequence at the time at which the pattern occurs; and
identifying the location of the loose connection based on the time at which the pattern occurs and the state of the switching sequence at the time at which the pattern occurs.

12. The method of claim 8 or 9, wherein identifying the location of the loose connection comprises:
modifying a switching sequence based on detecting the pattern corresponding to the loose connection.

13. The method of any 8 to 12, further comprising:
generating a notice to an operator of the electrical circuit (110), the notice including the location of the loose connection.

14. The method of any of claims 8 to 13, further comprising:
determining that the data pattern may indicate an intermittent loose connection, as distinguished from an external transient event, based on detecting the pattern at intermittent intervals; and
identifying the location of the loose connection by referring to a history of measured current or voltage and a history of a switching sequence to identify one or more previous instances of the loose connection.
